(19) Europäisches Patentamt
European Patent Office
Office européen des brevets

(11) **EP 0 991 184 B1**

(12) **EUROPEAN PATENT SPECIFICATION**

(45) Date of publication and mention
of the grant of the patent:
**22.04.2009 Bulletin 2009/17**

(51) Int Cl.:
*H03G 5/00* *(2006.01)*    *H03H 17/02* *(2006.01)*

(21) Application number: **99203190.6**

(22) Date of filing: **30.09.1999**

(54) **Digital tone control with linear step coefficients**

Digitale Klangregelung mit Koeffizienten in linearen Schritten

Contrôle numérique de tonalité utilisant des coéfficients par pas linéaires

(84) Designated Contracting States:
**DE FR GB**

(30) Priority: **30.09.1998 US 102410 P**

(43) Date of publication of application:
**05.04.2000 Bulletin 2000/14**

(73) Proprietor: **Texas Instruments Incorporated**
**Dallas, Texas 75251 (US)**

(72) Inventors:
• **Allred, Rustin W.**
**Plano,**
**Texas 75023 (US)**

• **Young, Robert S.**
**Austin,**
**Texas 78733 (US)**
• **Tsecouras, Michael J.**
**Carrollton,**
**Texas 75007 (US)**

(74) Representative: **Holt, Michael**
**Texas Instruments Limited**
**European Patents Department**
**800 Pavilion Drive**
**Northampton NN4 7YL (GB)**

(56) References cited:
**EP-A- 0 135 066**    **EP-A- 0 326 672**
**US-A- 5 491 755**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

This invention relates to an improved method of implementing digital audio tone controls that produces a higher performance audio output signal without artifacts (noise or distortion) when changing tone control settings. is accomplished by using a unique, highly efficient method of changing digital filter coefficients. This invention applies to all applications that eliminate artifacts through real-time adjustability of digital filters.

DESCRIPTION OF THE RELATED ART

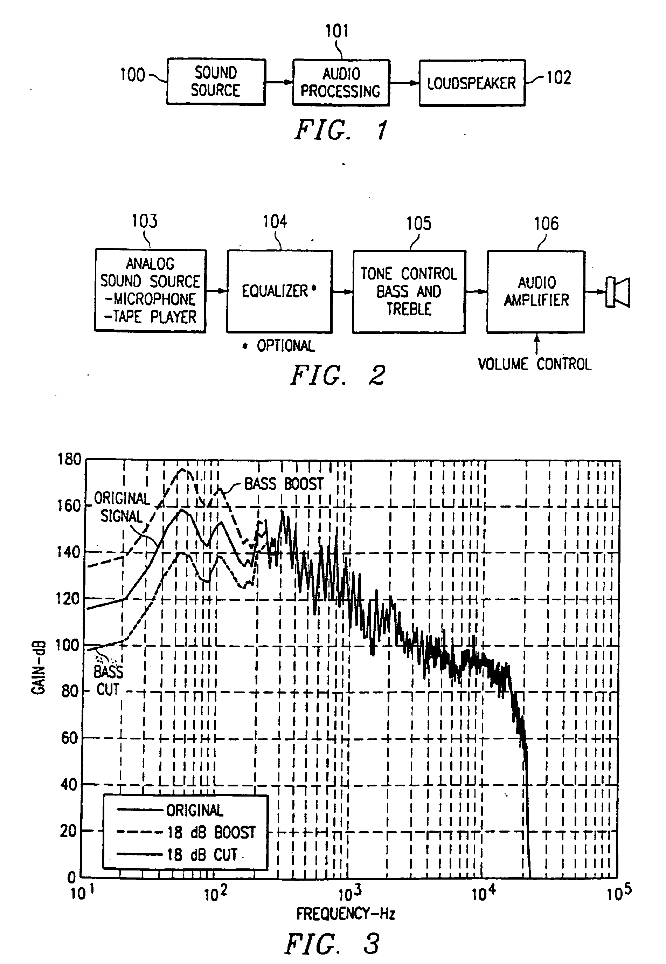

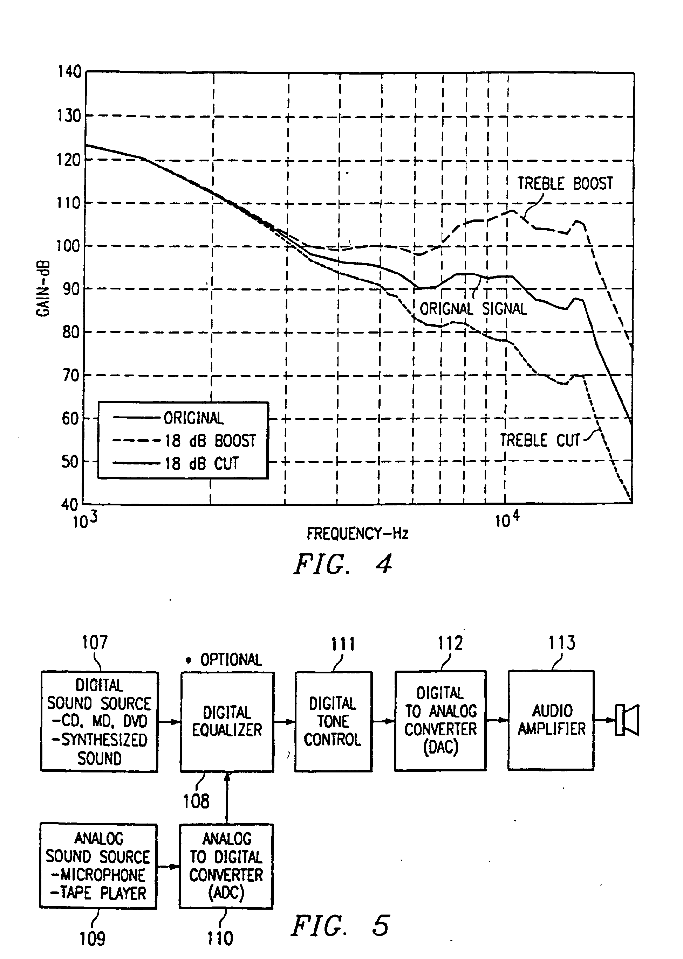

Processing of audio signals to improve their listening characteristics has long been a well understood and common area of technology. Sources of these audio signals are many and varied: radio and TV stations, tapes, CD's, PC's, and satellites to name only a few. Audio signals are an important part of everyone's life. To that end, clear, noise and distortion free listening is the goal of most audio systems. Adjustability of the broadband gain (volume), high-frequency gain (treble) and low-frequency gain (bass) are desirable if not necessary features for most audio systems.
Historically, systems have received analog audio signals. Even today most systems, are designed to receive and process analog audio signals without conversion. Figure 1 shows a block diagram of a typical audio system showing the source (100), the audio processing (101) and the loudspeaker (102) which translate the audio signal into sound that the human can hear. Figure 2 shows how a typical analog audio system is implemented. It shows, the source (103), an equalizer (104) which may be used to flatten the system spectral response, a tone control (105) which adjusts the gain in the particular (bass or treble) frequency range, an audio amplifier (106) which adjusts the overall signal strength and loudspeaker. Several comments concerning the equalizer and tone control are appropriate. As indicated, the equalizer flattens the system spectral response in the audio signal band. Usually, an ideal response is flat from approximately 20 Hz to 20 KHz. The tone control (bass and/or treble) is essential in most systems and can be used with or without the equalizer. Current high performance systems generally use an analog equalizer. As indicated, the tone control increases or decreases the audio signal gain in a particular frequency range. In the case of treble, the range is the high end of the audio band and is approximately 10 KHz and above. In the case of bass, the frequency range is the low end of the audio band and is approximately 20 Hz to a few hundred Hz. Figure 3 shows a typical audio spectrum with the impact of the tone control bass boost and cut of +/- 18 dB. The impact is primarily below 100 Hz. The middle plot is the original signal. Figure 4 shows a typical audio spectrum (averaged for clarity) with the impact of the tone control treble boost and cut of +/- 18 dB. As in Figure 3 the middle plot is the original signal. The upper and lower plots are the original signal with either boost (increased gain) or cut (reduced gain) respectively.
The advantages of the analog systems are: 1) the natural world is analog and even today many signals are produced in analog format, 2) well-implemented analog systems produce excellent sound, with little or no perceived distortion, particularly for high performance systems and 3) there is a large inventory of history and experience among analog designers. However, the analog systems do have some limitations. The world is rapidly converting to digital systems because of the high cost of analog compared to digital systems, and the improved flexibility and programmability as well as their ease of storing and transmitting data. In analog systems, the systems performance tends to be limited by the characteristics of the available components, and systems tend to be hard-wired. This is not the case with digital systems.
The advantages of digital audio systems are well known but will be summarized for clarity. First, and foremost, digital systems offer performance advantages not available in analog systems. These advantages arise from the ability of digital systems; 1) to implement most any mathematical function, 2) immunity to noise and 3) programmability. In general, digital systems will also be less expensive, often significantly, than their similarly performing analog counterparts.
Because of the many advantages of digital systems, analog audio systems are beginning a rapid conversion either totally or in part to digital technology. Digital inputs from such audio systems as Compact Disks (CD's), introduced in the early 1980's by Sony, combined with inputs from such standard digital audio interfaces as AES/ EBU-SPDIF and IEEE 1394 are forcing system designers to consider total digital audio systems, including equalizers and tone control. For the most part, audio amplifiers and loudspeakers are likely to remain analog for the foreseeable future. Digital audio signals are converted to analog after processing using well known Digital-to-Analog Converters (DAC) technology, prior to amplification and input to the speaker. In fact, today the output of many commercial products/systems are now digital rather than analog, such as Digital Video Disk (DVD), Digital Tape, Direct Satellite broadcasting, High Definition TV (HDTV) broadcasting and many others. Most entertainment content including audio is now produced and processed digitally by the content providers.
The block diagram of a conceptual "known art" hybrid digital audio system is shown in Figure 5. A digital system is implemented as shown in the top portion of Figure 5. It contains a digital sound source (107), a digital equalizer (108), which is optional, a digital tone control (111) and a DAC (112) to convert the processed digital audio signal back to analog for input into the audio amplifier (113) and speaker. Since much content (input signals) is still in analog form, systems may be designed to accept either analog or digital signals. The lower portion of Figure 5 shows the Analog-to-Digital conversion (ADC) function (110) added to the system to produce a hybrid analog/digital system, able to receive and process digital or analog signals. Although such a hybrid system is not yet typical in the marketplace, it is considered known art since the literature implies it. This invention makes such a system more feasible.

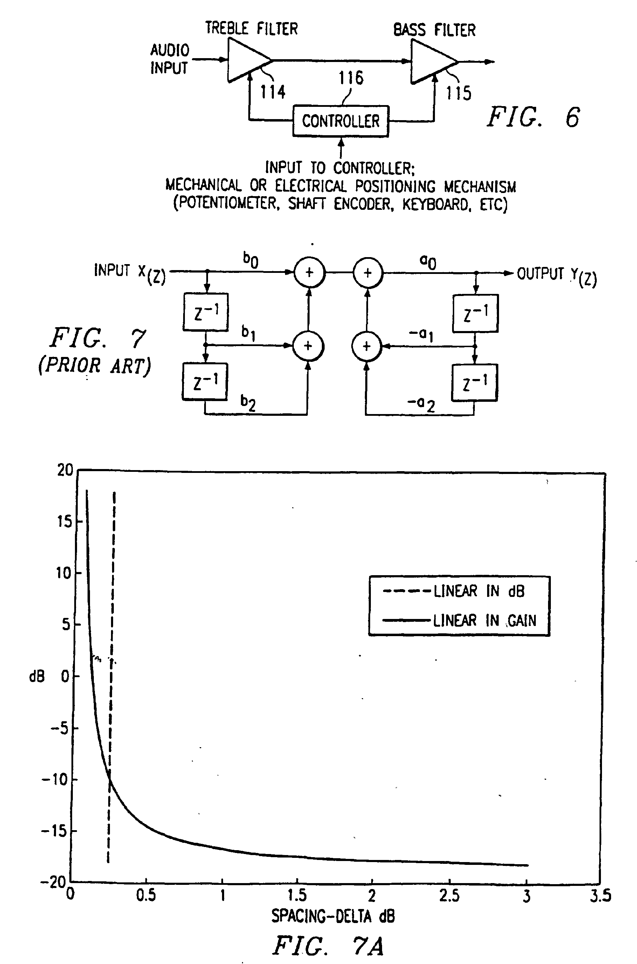

This invention relates to a method for the tone control section of the digital audio system described in Figure 5. Known art for implementation of the digital tone control for a single channel is shown in Figure 6. The typical audio system would include a separate digital filter for treble (114) and bass (115) in each channel, controlled by some form of integrated circuit controller (116). Figure 5 shows only one channel, however the second or multiple channels would each be identical and controlled by the same processor (116). The input processor (116) can be a microprocessor (uP), microcontroller (uC), Digital Signal Processor (DSP) or custom controller, whichever may be available in the system or is the most cost effective. DSP's are particularly well suited and very efficient for the type of mathematics required to control and store the information to implement and change digital filters. The tone control input to the controller can be produced by either a mechanical or electrical stimulus. Mechanical inputs from potentiometers, keyboards and shaft encoders converted to electrical inputs are common.

The filters used in the digital tone control are Shelving filters. In this application, Shelving filters converge toward 0 dB in the center of the audio band, and toward some finite value at the band edge. Although many filters have parameters that remain fixed during use, the parameters of audio tone control filters must be adjustable.

The operation and mathematics of digital filters are widely discussed in the following reference: 1) Proakis & Manolakis, "Introduction to Digital Signal Processing", MacMillan Publishing Co., 1998.

Digital filters for audio processing are discussed in detail in the following references: 1) Yinong Ding & David Rossum, "Filter Morphing of Parametric and Shelving Filter for Audio Signal Processing", Pages 821-826, Journal of Audio Engineering Society, Volume 43, No. 10, October 1995. 2) Mourjopoulos, Kyriakis-Bitzaros and Goutis, "Theory and Real-Time Implementation of Time-Varying Digital Audio Filters", Pages 523-536, Journal of the Audio Engineering Society; Audio/Acoustics/Applications, Volume 38, Number 7/8, July/August 1990.3) Zoelzer, Redmer and Bucholtz, "Strategies for Switching Digital Audio Filters", Audio Engineering Society (AES) Reprint, Number 3714 (B1-PM-6), presented at AES Convention in New York on October 7-10, 1993.

A typical digital filter architecture can be defined as shown in Figure 7. Where $a_o$, $a_1$, $a_2$ & $b_o$, $b_1$, $b_2$ are the filter coefficients and $z^{-n}$ is a delay of n samples. The transfer function of the filter can be described as:

$$Hz = Y(z) = \frac{b_o + b_1 * z^{-1} + b_2 * z^{-2}}{a_o + a_1 * z^{-1} + a_2 * z^{-2}} \qquad \text{Equation 1}$$

Where: Y(z) is the audio output signal (frequency domain) and X(z) is the input signal (frequency domain) In the references, the operation of digital filters is discussed in detail and is well known to those in the trade. According to the referenced literature, filter coefficients should be changed in such a way that the filter response sequences through a number of small (fraction of a dB), exponentially equal filter steps when traversing between the current and desired gain settings.

When testing this concept of digital tone control, on a digital audio system using the CD digital audio output, 16 bit signal and a sample rate of 44.1 KHz, it was found that undesirable artifacts were introduced. These artifacts take the form of noise or distortion, such as clicks, pops and zipper noise (a series of pops) as the bass and treble levels were adjusted. It was thought that smaller filter steps (down to 0.01 dB) might solve the problem, but artifacts were still present when the smaller steps were used. This was particularly true with treble control. The large number of smaller steps, in itself introduces additional problems for the designer. These are: 1) implementation time; as an example, 0.01 dB steps require 3600 settings for a +/- 18 dB audio control range. 2) increase in programming complexity and 3) additional potential cost of increased memory size requiring a larger semiconductor die.

In European Patent EP 0 326 672 there is described an arrangement for avoiding spurious behaviour in changing filter coefficients.

The present invention provides processes as set forth in the claims. Also described is a very efficient method of implementing the complex digital Shelving filter coefficients used in both the treble and bass tone controls. This will be applicable where there are limitations, such as 1) memory storage space, 2) processor computational power, 3) integrated circuit die size available and/or 4) other cost considerations. Typically, this efficient method could be very important for small, cost sensitive, moderate-high performance stand-alone audio systems, while the method of eliminating artifacts is applicable to any digital tone control implementation.

Digital audio tone control may be implemented using Shelving filters. It was found that the digital audio treble tone control exhibited artifacts (noise, distortion, etc.) as the tone control settings were changed. This was previously accomplished by changing filter coefficients in the traditional small equal (on a dB scale) filter steps of a fraction of 1 dB. While this worked for bass filters, artifacts were still present for treble. This invention found that these artifacts could be eliminated by changing the filter steps to small equal steps on a linear scale. Additionally, where the steps became too large for the resolution required, additional filter steps were added. 150 filter steps were used for treble control and 128 filter steps were used for bass tone control.

A very efficient way of implementing the filter steps for digital tone control is described. Instead of storing all of the filter coefficients, or the equations for the calculation of filter coefficients and then calculating each coefficient step, this invention stores one set of filter coefficient values and a small amount of additional information and then increments the coefficients between all the other steps. This invention can reduce the memory required by as much as 95% or the machine cycles for implementing filter coefficients by 40-200 times. This new efficient method is accomplished by: 1) redefining the filter coefficients, 2) piecewize linearizing the plot of filter coefficients versus filter step to define the linear regions, 3) defining the initial set of filter coefficients, and 4) defining increments between filter steps.

BRIEF DESCRIPTION OF DRAWINGS

The present invention will now be further described, by way of example, with reference to certain exemplary embodiments illustrated in the accompanying drawings in which:

Figure 1 is a block diagram of a "Typical Audio System", including the sound source, audio processing section, and the loudspeaker.
Figure 2 is a block diagram of a "Typical Analog Audio System", including the sound source, equalizer, tone control for base and treble, audio amplifier and speaker.
Figure 3 is a graph of "Typical (unnormalized) Audio Spectrum" and the resultant signal after tone control bass cut or boost over +/- 18 dB range.
Figure 4 is a graph of "Typical (unnormalized) Audio Spectrum" (averaged for clarity) and the resultant signal after tone control treble cut or boost over +/- 18 dB range.
Figure 5 is a block diagram of a "Conceptual Hybrid (Digital and Analog) Audio System".
Figure 6 is a block diagram of a one channel for a "Typical Digital Tone Control System".
Figure 7 is a diagram of a "Typical Digital Filter Architecture".
Figure 7A is a graph of a "Plot of Filter Gain in dB Versus Delta dB of the Filter Steps for both Equal Linear Steps and Equal dB Steps".
Figures 8A and 8B are graphs of the "Treble Filter Gain Versus Frequency" using both a linear dB scale and a linear scale for 20 output steps between +/- 18 dB.
Figure 9 is a graph of a "Treble Audio Tone Control Filter Gain Versus Frequency" for 128 digital Shelving filters with equal linear filter steps between +/- 18 dB.
Figure 10 is a graph of a "Final Digital Treble Filter Gain Versus Frequency" plot for 150 Shelving filter steps between +/-18 dB where the 128 filter steps are uniformly spaced on a linear scale and 22 additional filter steps are added for resolution to optimize listening pleasure and provide reasonable adjustability by the user.
Figures 11A, 11B, 11C, 11D and 11E are graphs of the "Filter Coefficients Versus the Filter Step" for each of the filter transfer function variables ($a_1$, $a_2$, $b_0$, $b_1$, $b_2$) for the digital audio treble tone control concept used.
Figures 12A, 12B, 12C, 12D and 12E are graphs of the "Filter Coefficients Versus the Filter Step" for each of the filter transfer function variables ($a_1$, $a_2$, $b_0$, $b_1$, $b_2$) for the digital audio bass tone control concept used.
Figure 13 is a graph of the "Final Digital Bass Filter Gain Versus Frequency" for the 128 digital Shelving filters where the filter steps are uniformly (equal) spaced on a linear dB scale for a +/- 18 dB range.
Figure 14 is a functional block diagram of the hardware implementation of the digital treble and bass tone control described in this invention.

DETAILED DESCRIPTION

This invention will describe a new and very unique way of designing a method for a digital audio tone control system that will eliminate artifacts as the treble tone controls are changed. Also described will be a very efficient method of implementing the complex Shelving filters used in both the treble and bass tone controls. This will be applicable where there are limitations, such as 1) memory storage space, 2) processor computational power, 3) available die size for memory and/or 4) cost considerations.

The initial consideration leading to this invention was removal of the artifacts that can occur when the bass and treble controls are adjusted by changing the digital filter coefficients. Experiments were performed where the filter coefficients were changed with varying granularity. The time lapse between coefficient changes was also varied. Subjective listening tests indicated that the bass adjustment is much less susceptible to audible artifacts than the treble adjustment. It was discovered that audible artifacts would occur in the treble adjustment even if the granularity of the change was a small fraction of a dB. A method to eliminate the treble artifacts is a claim of the invention. It was found that changing the Shelving filter coefficients such that the gain of the treble filter changes linearly, as opposed to logarithmically as in the traditional dB scale, would eliminate artifacts.

The concept of changing the filter steps in equal increments on a linear basis versus the standard equal increments on a dB basis needs further explanation. The plot in Figure 7A shows a plot of the filter gain in dB versus the delta dB of the filter steps for equal linear steps and the known art and more traditional equal dB steps. As expected when plotting equal dB steps, a straight line at the defined dB step delta is obtained. In the plot (dotted line) the dB spacing is 0.25 dB equally spaced between all filter steps. Plotting equal linear spacing between filter steps shows a much different outcome. As the gain traverses from + 18 dB to -10 dB, the filter steps increase gradually on a dB scale, but as traversal continues between - 10 dB and -18 dB the filter steps become large. This is significant because steps greater than 1 dB are a problem for the designer, as will be discussed later.

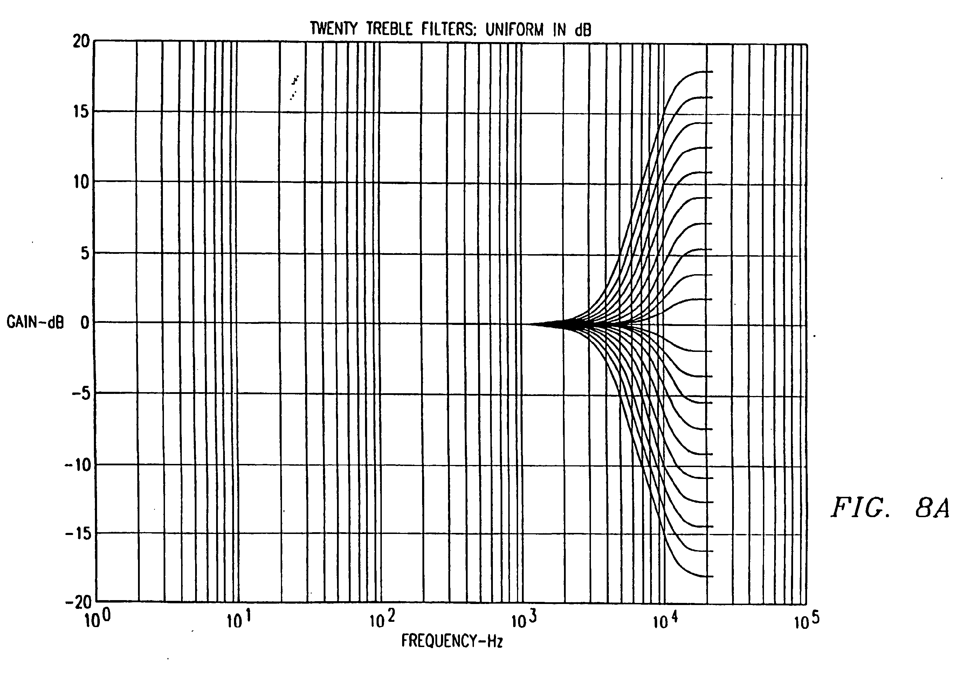

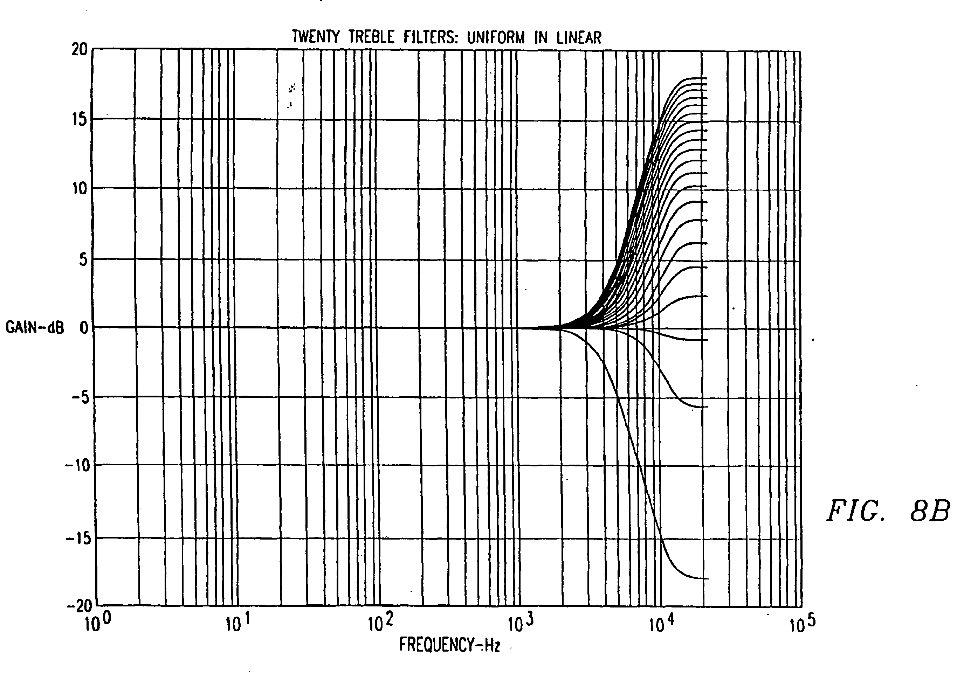

Figure 8 shows the conceptual difference between the frequency responses of digital filters that might be used in a digital treble tone control as the filter traverses uniformly on a traditional dB scale (left chart) or standard linear scale (right chart) in 20 steps over a +/- 18 dB range. The plot on the left (Figure 8A) is the treble digital filter frequency response Hz for twenty digital Shelving filters with uniform (equal) dB steps. The plot in Figure 8B is the treble filter frequency response for twenty digital shelving filters with uniform linear steps between +/- 18 dB.

While changing the gain in uniform linear increments helps to eliminate artifacts, it is still necessary to change the gain in small increments. Further, the listening experience is greatly enhanced by leaving some amount of delay between coefficient changes. It was determined that 128 filters with uniform gain distribution and with approximately 64 samples (at 44.1 KHz) between treble gain changes was the best sounding configuration. This configuration sounds much like analog controls. This need not be exactly 128 filters or 64 samples. This general approach will eliminate artifacts. The values 128, and 64, as well as other various coefficients described below, represent one working embodiment of this concept. When the treble adjustment is made, a move is made through each of the filters between the old gain level and the new, with a delay of 64 samples between each change.

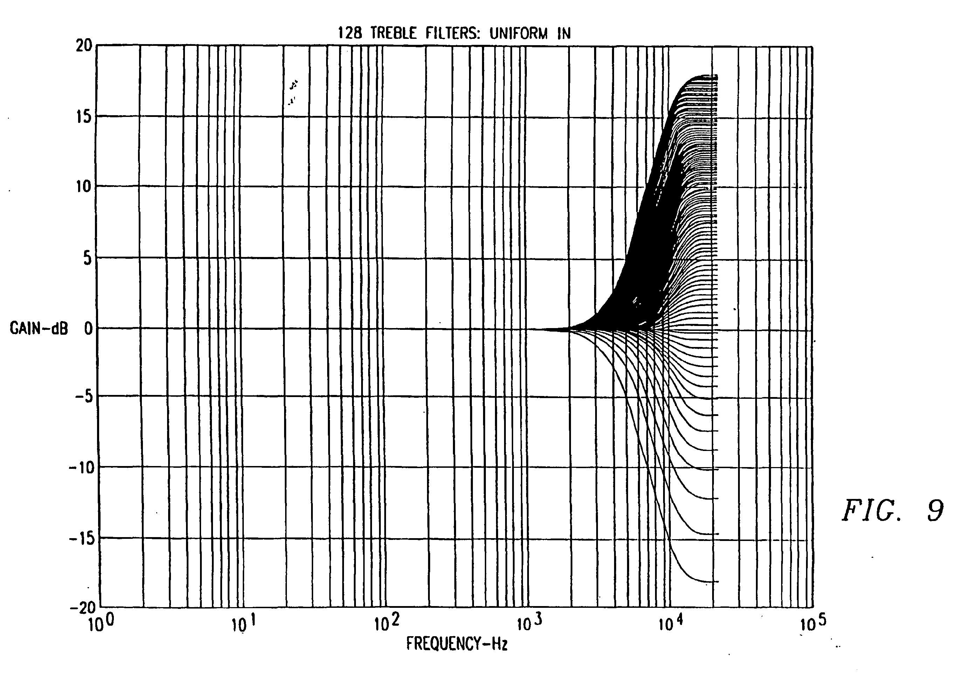

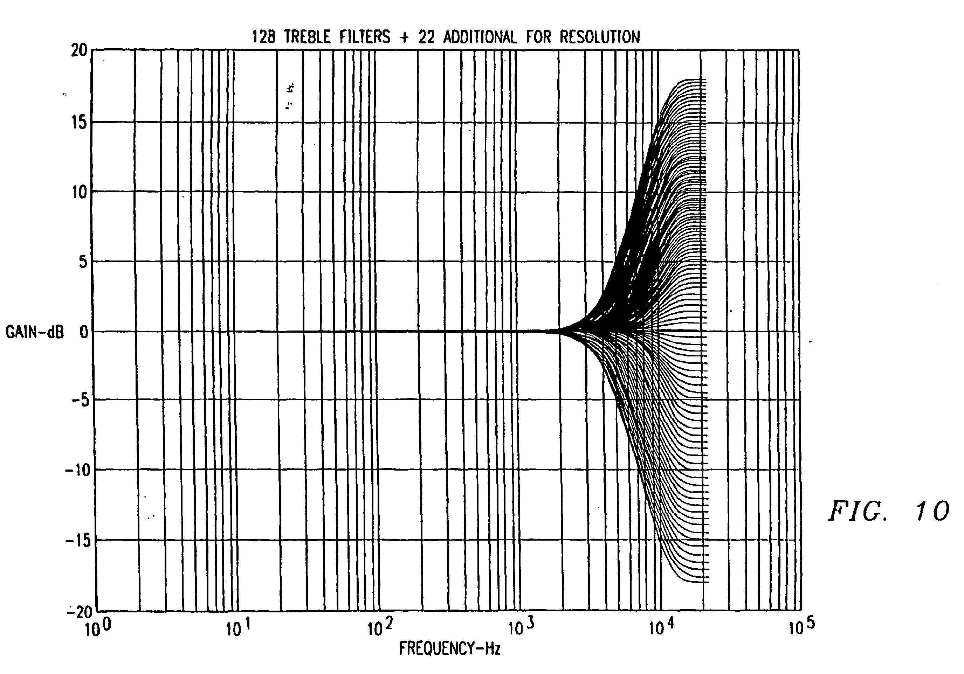

Throughout the investigation treble and bass control ranges of $\pm 18$ dB with 100 Hz corner frequencies for bass and a 10 KHz corner for treble were assumed. These parameters are easily changed and do not affect the overall architecture. Figure 9 shows the treble filter gain versus frequency for 128 Shelving filters with uniform linear spacing between +/- 18 dB. However, in considering the series of filter plots in Figure 9, it is clear that there are places where, if only these filters were used, the adjustability resolution is too low. For example, there is a 4 dB gap between -18 dB and the next filter. Generally the user will want resolution steps smaller than 1 dB. Adding additional filters for more resolution is no problem since what is shown in Figure 9 is the minimum set of filters to prevent audible artifacts. For this reason the following approach was chosen: 1) maintain the 128 original filters, and 2) add twenty two (22) additional filters between them to fill in the gaps and provide the necessary resolution. Such a set of filters is shown in Figure 10. Additional listening tests verified that the filter set of Figure 10 did indeed provide an artifact-free, pleasant listening experience while offering the desired adjustability resolution.

With this new invention filter updating or incrementing is accomplished simply. An input word indicates the new gain setting and the device simply steps through each of the filters between the current setting and the new tone control setting, filtering 64 samples between each step. In this invention, all of the necessary filters are pre-defined in the device, and all transitions are implemented in the same way. The second portion of this disclosure is to describe how filter coefficient changes can be efficiently and cost effectively implemented via a unique method.

Efficient and cost effective digital filter implementation

The filter set in Figure 10 contains 150 total filters. It is necessary that the device have definitions to all of them, and be able to move back and forth through each of them when the treble filter coefficient updates are made. However, storing all of these coefficients can be expensive. Therefore, a method that only requires storage of one set of filter coefficients and approximately six sets of updates or increments for those coefficients was developed. This process is described below.

The process is:

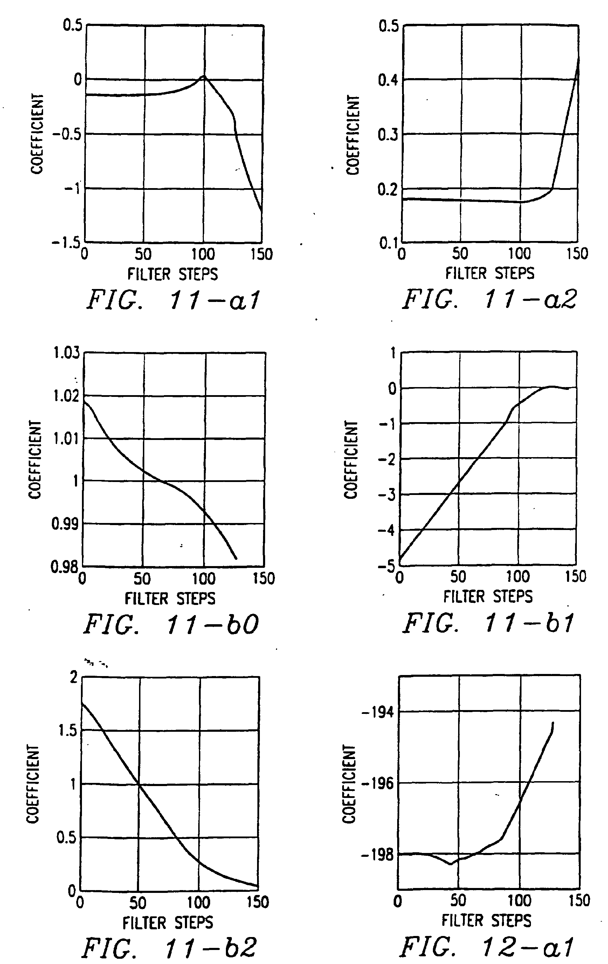

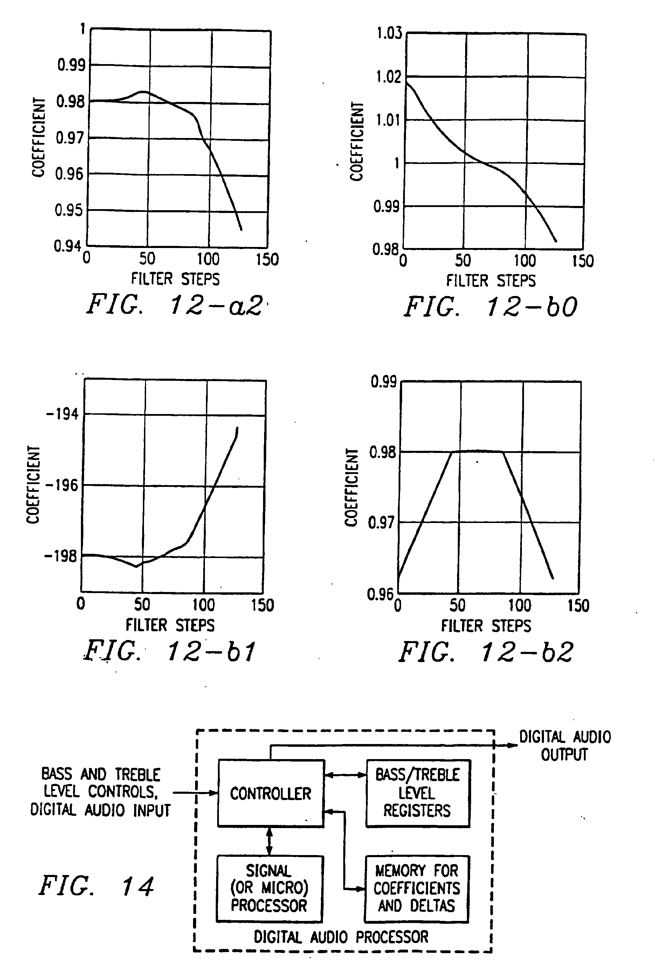

    1. Determine the set of Shelving filters to be used. (In the example treble case described, it is the set of 150 filters shown in Figure 10).
    2. Plot the filter coefficients as a function of filter step. (Figures 11 & 12)
    3. Piecewise linearize plots.
    4. Select the initial set of filter coefficients to use. (In this case the 0 dB coefficients are chosen as the default case).
    5. Determine, based upon the piecewise linearization in step 3, the deltas or increments to be used when changing the filter coefficients.

6. Adjustment to the piecewize linearization may be required to minimize deviations from the desired filter response.

Figure 11 shows the plots described in step 2 of the prior process. For the final treble configuration in Figure 10, the plots are of the treble shelving filter coefficients for $b_0$, $b_1$, $b_2$, $a_1$ & $a_2$ plotted versus the filter steps from 1-150 for a +/- 18 dB range. , Coefficient $a_0$ is always defined as 1 and is not plotted.

By storing one set of coefficients and a small amount of update (increment) information, the filters necessary for implementing the entire suite in Figure 10 can be computed simply. In the example shown, one set of coefficients and 5 or 6 sets of deltas are stored for the implementation. The computational burden is very light. This is a very low cost method of storing a large number of coefficients. Although this technique is general and can have various specific implementations, one example is shown.

When comparing this simplified and very efficient approach of incrementing for multiple filter changes to other possible methods of 1) storing the formulas and calculating the coefficients or 2) storing a complete set of coefficients, one can immediately see the significance. The implementation of calculating all the filter coefficients from a stored formula would require in the range of 40-200 times the number of machine (controller) cycles required to execute the incrementing approach discussed in this invention. The memory required in this particular tone control application using the new simple technique would require storage of approximately 30-35 (24 bit) words versus 640-750 words if the coefficients were stored, a 95% reduction. Memory is typically inexpensive in an integrated circuit implementation, but, it can be expensive to add additional blocks of memory when available memory capacity has been reached.

Simulation as well as hardware implementation in silicon of both treble and bass (to be discussed later) was accomplished and verified the excellent results. The simulation software package used was Matlab, Release 5.1, April 97. This is a product of The Math Works, 24 Prime Parkway, Natick, Ma. 01760. Before hardware implementation, the treble and base control techniques were prototyped using the standard Matlab software package. In the simulation, 16 bit, 44.1 KHz digital audio signal selections, in the form of wave files (a binary format) were processed. The treble and bass levels were moved through some preset patterns and were also moved to various random values. Evaluation was performed by outputting wave files to a CD and listening to the music for any processing artifacts in either the treble or bass.

The treble filter shown in Figure 10 (150 filter steps) was implemented as follows: The initial floating point filter coefficients for 0 dB (Filter Step 114) are shown:

B = [ $b_0$, $b_1$, $b_2$ ] = [1.00000000000000, -0.17123848513638, 0.17676118948322]

A = [ a0, a1, a2 ] = [1.00000000000000, -0.17123848513638, 0.17676118948322]

Formula 2: Treble filter coefficients for 0 dB All data is Matlab notation where applicable. The coefficients are for a filter with the definition shown in equation 1.

Table 2 shows the increments (updates) used to determine the filter coefficients for the specified filter step of the plots in Figure 11.

Table 2. Floating point coefficient increments (updates) versus Filter Step for digital treble tone control

| *Treble Shelving Filter Coefficient Increments* | | | |
|---|---|---|---|
| Filter-steps/Equation | $a_0$, $b_0$ | $a_1$, $b_1$ | $a_2$, $b_2$ |
| 1:79 / B | 0.02653228920529 | -0.04275831648700 | 0.01550691716392 |
| 1:79 / A | 0 | -7.543783385381142 e-004 | 3.526822075566871 e-005 |
| 80:97 / B | 0.02943649194725 | -0.05000527961919 | 0.01346749191064 |
| 80:97 / A | 0 | -0.00719677714679 | 0.00009548138550 |
| 98:113 /B | 0.02785981884054 | -0.02237505711761 | 0.00660525302211 |
| 98:113 /A | 0 | 0.01240607471399 | -0.00031605996896 |
| 114:125 /B | 0.02605065361594 | -0.01602361396586 | 0.00489245334215 |
| 114:125 /A | 0 | 0.01650483548648 | -0.00158534249424 |
| 126:150 /B | 0.01840801549960 | 0.00253343212643 | 0.00311561817545 |
| 126:150 /A | 0 | 0.03380670632966 | -0.00974964052817 |

The column on the left represents the filter step range of interest. The values across the top of the table are the filter coefficient increments (updates) of the variables ($a_0$, $a_1$, $a_2$, $b_0$, $b_1$, $b_2$) as appropriate. Upon initialization, the 0 dB coefficients are loaded (Formula 2). When commanded to a different treble setting, each intermediate filter setting is traversed. This is done by adding (when moving to a lower filter step) or subtracting (when moving to a higher filter) the appropriate incremental values from the coefficients. The lowest filter step is 1 and the highest is 150. Coefficient $a_0$ is always 1 so the delta is zero and no operation needs to be performed. When moving through 0 dB the actual initial coefficient is used, rather than calculated. Care must be taken to check for different increments at the breakpoints (of filter step ranges). Notice that the region 126:150 has different increments than region 114:125. In incrementing the filter number, the increment used is that associated with the current filter. So, when the transition from 125 to 126 is made, the increment for the 114:125 filter steps are used. When moving from 126 to 127, however, the increments for the 126: 150 filter steps are used. When the command is received to move to a next lower filter, the increment used is that associated with the next destination region. This means that in moving from 127 to 126, the increments for the filter steps 126:150 are added. And in moving from 126 to 125 the increments for the filter steps 114:125 are added.

For a sample rate of 44.1 KHz, approximately 64 samples should be filtered with each set of coefficients before moving on to the next set. This number should be changed somewhat when using significantly different sample rates, since it is important to keep a similar time constant or delay between filter setting changes. (Note; the filter coefficients themselves are also sample rate dependent so they must be redefined if a different sample rate is to be used).

Various audio selections have been processed using these new filters and implementation described in this invention. In these demonstrations the filters were indexed through the entire range, and also indexed through random ranges. They prove to provide a pleasant listening experience, without artifacts.

One potential concern with this type of approach is the possibility of numerical instability if the filters are adjusted many times without reinitialization. However, since there is no random element to the coefficient calculation - a known, fixed quantity is added or subtracted with each increment or update - the coefficient values stay well behaved. This point was also verified through simulation.

Bass Filters

It was observed that the digital audio bass tone control adjustment is much less susceptible to artifacts than the treble adjustment. While the treble digital tone control technique previously discussed, i.e. linear steps between filter positions, does an effective job on the bass control, it turns out that the bass coefficients are much more sensitive to minor errors in the filter coefficients. Hence, to piecewise linearize the coefficient plots with enough accuracy, using the treble invention of linear spacing described, it becomes more expensive for bass than for treble. Since the bass is an easier problem, it was decided to approach the problem a little differently in order to keep the implementation cost low. The approach uses many of the concepts described for treble control, but modified for the bass situation. In this case, 128 bass filters were uniformly distributed (the normal technique) in dB across the $\pm 18$ dB range. This provides adequate resolution, a pleasant listening experience (for the bass case only), and makes the coefficients somewhat less susceptible to error than if they are uniformly distributed in linear space as the treble coefficients described in this invention. Notice that, in the best case, fewer than 128 filters would provide adequate resolution. However, the additional filters are necessary to prevent excessive gaps and give the listener the expected resolution, between filter steps after piecewise linearization.

In this case, the (floating point) 0 dB coefficients are at filter step 64. These are shown below:

$$B = [1.00000000000000 \ -1.97985204614398 \ 0.98005300183903]$$

$$A = [1.00000000000000 \ -1.97985204614398 \ 0.98005300183903]$$

Formula 3: Bass filter coefficients for 0 dB

Even with the change in gain distribution for the bass coefficients, the increments are still slightly more difficult than for the treble case. For bass, 6 linear regions were used for piecewise linearization, as opposed to the 5 used for treble. The increments for the entire 128 filter steps are shown in Table 3. The coefficients and increments shown are floating point values. Fixed-point implementations are also possible as long as adequate precision is maintained. If the available precision is too low, the resulting filter responses might deviate for the original. To some extent, this problem can be minimized by adjusting the original filters such that the resulting filters will exhibit the proper responses.

Bass Shelving Filter Coefficient Increments

Table 3: Floating point coefficient increments versus filter step for digital bass tone control

| Filter Steps/Equation | $a_0, b_0$ | $a_1, b_1$ | $a_2, b_2$ |
|---|---|---|---|
| 1:26 B | 3.946449554792508 e-004 | 4.830567905522720 -e-005 | 4.062466274090682 e-004 |
| 1:26 A | 0 | 3.024571660614761 -e-005 | 2.966163437889690 e-005 |
| 27:42 B | 2.857287077275838 e-004 | 1.495963324777971 -e-004 | 4.145550005097976 e-004 |
| 27:42 A | 0 | 1.404639522857298 -e-004 | 1.379586729745030 e-004 |
| 43:63 B | 1.668071537030968 -e-004 | 1.487609149517510 e-004 | -1.407624674298891 e-005 |
| 43:63 A | 0 | -1.521377054942708 e-004 | 1.493541164174772 e-004 |
| 64:84 B | 1.659290781091949 -e-004 | 1.754733270684650 e-004 | 1.237547055510380 e-005 |
| 64:84 A | 0 | -1.788264141853180 e-004 | 1.749514615472236 e-004 |
| 85:108 B | 3.001079188583722 -e-004 | 7.057047575922404 e-004 | 4.036472607082952 e-004 |
| 85:108 A | 0 | -7.160843568969621 e-004 | 6.933755802618347 e-004 |
| 109:127 B | 4.065635951875368 -e-004 | -8.259826802887726 e-004 | 4.190901904891353 e-004 |
| 109:127 A | 0 | -8.456883624656797 e-004 | 8.059481034996541 e-004 |

Figure 12 shows the piecewise linearized plots of the bass shelving coefficients for $b_0$, $b_1$, $b_2$, $a_1$ & $a_2$ versus the filter steps from 1-127 for +/-18 dB range.

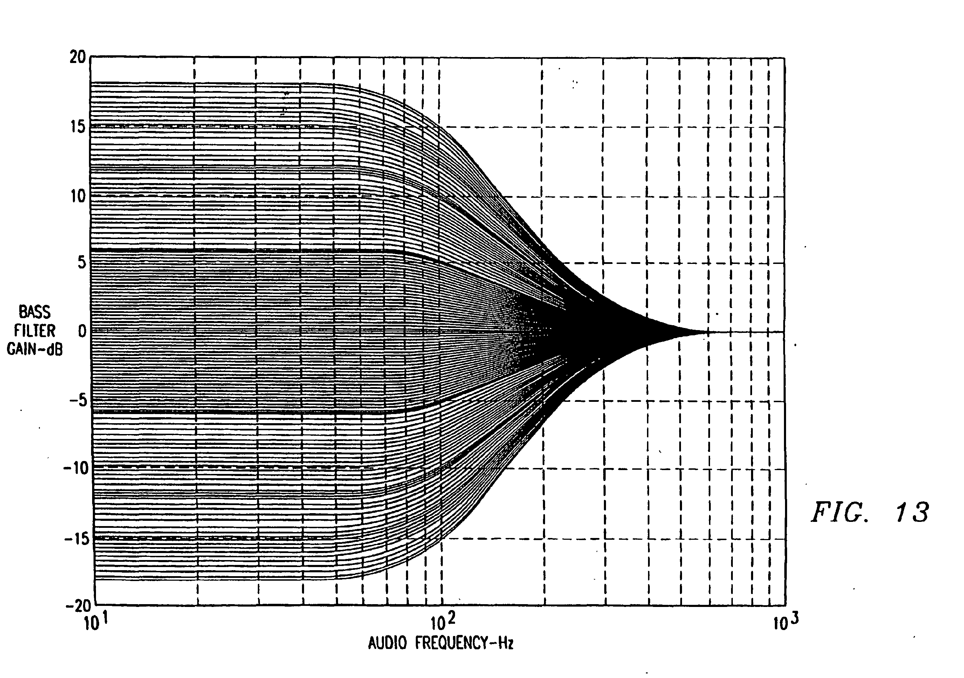

The bass filter gain versus frequency for all the filter steps arising from the bass coefficients and increments described are shown in dB vs. frequency in Figure 13.

The functional block diagram of the hardware implementation of this digital audio tone control (both treble and bass) concept is shown in Figure 14. The system is composed of: a tone controller (117), which integrates all the inputs; a processor(118), which controls the entire system; memory (119), which stores the current and desired audio treble and bass levels as well as the code, bass and treble filter coefficients and the filter step increments. This is a general implementation, and as long as the function is available, the block diagram is applicable.

This invention describes a new and very unique way of designing a method for a digital audio tone control system that will eliminate artifacts as the settings are changed. Also described is a very efficient method of implementing the complex digital Shelving filter coefficients used in both the treble and bass tone controls. This will be applicable where there are limitations, such as 1) memory storage space, 2) processor computational power, 3) integrated circuit die size available and/or 4) other cost considerations. Typically, this efficient method could be very important for small, cost sensitive, moderate-high performance stand-alone audio systems, while the method of eliminating artifacts is applicable to any digital tone control implementation. An efficient way of implementing the filter steps for digital tone control is described. Instead of storing all of the filter coefficients, or the equations for the calculation of filter coefficients and then calculating each coefficient step, this invention stores one set of filter coefficient values and a small amount of additional information and then increments the coefficients between all the other steps. This invention can reduce the memory required by as much as 95% or the machine cycles for implementing filter coefficients by 40-200 times. This new efficient method is accomplished by: 1) redefining the filter coefficients, 2) piecewize linearizing the plot of filter coefficients versus filter step to define the linear regions, 3) defining the initial set of filter coefficients, and 4) defining increments between filter steps.

**Claims**

1. A method of digital audio tone control comprising:

   A. implementing digital audio tone control using Shelving filtering that requires filter coefficients;
   B. defining a plurality of sets of said filter coefficients, each of said set defining a Shelving filter, such that the difference between the coefficients of the sets determine uniform steps of gain of said digital audio tone control on a linear scale;

C. defining additional sets of filter coefficients where the steps between sets of filter coefficients is larger than a desired resolution

D. selecting a one of said sets of filter coefficients to provide said filtering;

E. selecting an alternate one of said sets of filter coefficients; and

F. stepping through said sets of coefficients from said one set to said alternate set to effect said tone control.

**2.** The method of claim 1 including using approximately 150 sets of filter coefficients for treble tone control and 128 sets of filter coefficients for bass tone control.

**3.** The method of claim 1, or claim 2 **characterized by**:

storing one set of coefficients;

storing the differences between coefficients;

determining coefficients of other sets from said stored coefficients and said differences.

**Patentansprüche**

**1.** Ein Verfahren zur digitalen Audio-Ton-Steuerung, enthaltend:

A. Implementieren von digitaler Audio-Ton-Steuerung unter Verwendung von Kuhschwanz(Shelving)-Filterung, die Filter-Koeffizienten erfordert;

B. Festlegen einer Mehrzahl von Reihen von genannten Filter-Koeffizienten, wobei jede der genannten Reihen ein Kuhschwanz(Shelving)-Filter festlegt, in solcher Weise, dass die Differenz zwischen den Koeffizienten der Reihen gleichförmige Stufen der Verstärkung der genannten, digitalen Audio-Ton-Steuerung auf einer linearen Skala festlegt;

C. Festlegen zusätzlicher Reihen von Filter-Koeffizienten, in denen die Stufen zwischen Reihen von Filter-Koeffizienten größer sind, als eine gewünschte Auflösung

D. Auswählen von einer der genannten Reihen von Filter-Koeffizienten, um genannte Filterung zu leisten;

E. Auswählen einer alternativen Reihe der genannten Reihen von Filter-Koeffizienten; und

F. Fortschalten durch genannte Reihen von Koeffizienten von einer Reihe zur genannten, alternativen Reihe, um genannte Ton-Steuerung zu erzielen.

**2.** Das Verfahren nach Anspruch 1, einschließlich der Verwendung von etwa 150 Reihen von Filter-Koeffizienten für Hochton-Steuerung und 128 Reihen von Filter-Koeffizienten für Tiefton-Steuerung.

**3.** Das Verfahren nach Anspruch 1 oder Anspruch 2, **gekennzeichnet durch**:

Speichern einer Reihe von Koeffizienten;

Speichern der Differenzen zwischen Koeffizienten;

Bestimmen der Koeffizienten von anderen Reihen aus genannten, gespeicherten Koeffizienten und genannten Differenzen.

**Revendications**

**1.** Procédé de contrôle numérique de tonalité audio comprenant :

A. la mise en application d'un contrôle numérique de tonalité audio en utilisant un filtrage Shelving qui requiert des coefficients de filtre ;

B. la définition d'une pluralité d'ensembles desdits coefficients de filtre, chacun desdits ensembles définissant un filtre Shelving, de telle sorte que la différence entre les coefficients des ensembles déterminent des pas de gain uniformes dudit contrôle numérique de tonalité audio sur une échelle linéaire ;

C. la définition d'ensembles supplémentaires de coefficients de filtre où les pas entre les ensembles de coefficients de filtre sont plus grands qu'une résolution désirée ;

D. la sélection de l'un desdits ensembles de coefficients de filtre de manière à fournir ledit filtrage ;

E. la sélection d'un autre desdits ensembles de coefficients de filtre ; et

F. le passage à travers lesdits ensembles de coefficients à partir dudit un ensemble jusqu'au dit autre ensemble de manière à effectuer ledit contrôle de tonalité.

2. Procédé selon la revendication 1, incluant l'utilisation de 150 ensembles de coefficients de filtre pour le contrôle de tonalité aiguë et de 128 ensembles de coefficients de filtre pour le contrôle de tonalité grave, approximativement.

3. Procédé selon la revendication 1 ou la revendication 2, **caractérisé par** :

le stockage d'un ensemble de coefficients ;

le stockage des différences entre les coefficients ;

la détermination des coefficients des autres ensembles de coefficients à partir desdits coefficients et desdites différences stockés.

FIG. 1

FIG. 2

FIG. 3

FIG. 4

FIG. 5

FIG. 6

FIG. 7
(PRIOR ART)

FIG. 7A

FIG. 8A

FIG. 8B

TWENTY TREBLE FILTERS: UNIFORM IN LINEAR

FIG. 9

128 TREBLE FILTERS + 22 ADDITIONAL FOR RESOLUTION

FIG. 10

EP 0 991 184 B1

FIG. 11-a1

FIG. 11-a2

FIG. 11-b0

FIG. 11-b1

FIG. 11-b2

FIG. 12-a1

FIG. 12-a2

FIG. 12-b0

FIG. 12-b1

FIG. 12-b2

FIG. 14

FIG. 13

EP 0 991 184 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0326672 A

### Non-patent literature cited in the description

- **PROAKIS ; MANOLAKIS.** Introduction to Digital Signal Processing. MacMillan Publishing Co, 1998
- **YINONG DING ; DAVID ROSSUM.** Filter Morphing of Parametric and Shelving Filter for Audio Signal Processing. *Journal of Audio Engineering Society,* October 1995, vol. 43 (10), 821-826
- **MOURJOPOULOS ; KYRIAKIS-BITZAROS ; GOUTIS.** Theory and Real-Time Implementation of Time-Varying Digital Audio Filters. *Journal of the Audio Engineering Society; Audio/Acoustics/Applications,* July 1990, vol. 38 (7, 8), 523-536
- **ZOELZER ; REDMER ; BUCHOLTZ.** Strategies for Switching Digital Audio Filters. *Audio Engineering Society (AES) Reprint,* 07 October 1993